# EUROPÄISCHE PATENTSCHRIFT

(11) **EP 3 369 296 B1**
(45) Veröffentlichungstag und Bekanntmachung des Hinweises auf die Patenterteilung: **26.08.2020**
(21) Anmeldenummer: 16760711.8
(22) Anmeldetag: 05.09.2016
(51) Int. Cl.: H05K 5/00, H05K 7/20, F16H 61/00, B60R 16/023

(54) **STEUERVORRICHTUNG FÜR EINE GETRIEBESTEUERUNG EINES KRAFTFAHRZEUGS**
CONTROL DEVICE FOR A GEARBOX CONTROL SYSTEM OF A MOTOR VEHICLE
UNITÉ DE COMMANDE POUR COMMANDE DE BOÎTE DE VITESSES D'UN VEHICULE AUTOMOBILE

(30) Priorität: 29.10.2015 DE 102015221149
(43) Veröffentlichungstag der Anmeldung: 05.09.2018
(73) Patentinhaber: Robert Bosch GmbH, 70442 Stuttgart (DE)
(72) Erfinder: MICHEL, Heiko, 70839 Gerlingen (DE); WETZEL, Gerhard, 70825 Korntal-Muenchingen (DE); BERGER, Torsten, 71686 Remseck am Neckar (DE)
(86) Internationale Anmeldenummer: PCT/EP2016/070859
(87) Internationale Veröffentlichungsnummer: WO 2017/071860

(56) Entgegenhaltungen:
- EP-A1- 1 677 583
- EP-A2- 1 732 131
- DE-A1- 10 127 268
- DE-A1-102010 016 279
- DE-A1-102013 212 398
- DE-A1-102013 223 542
- DE-C1- 19 722 357
- DE-T5-112013 004 625
- US-A1- 2005 201 069

## Beschreibung

### Gebiet der Erfindung

Die Erfindung betrifft eine Steuervorrichtung für eine Getriebesteuerung eines Kraftfahrzeugs.

### Stand der Technik

Es ist bekannt, Steuervorrichtungen für Getriebe im Inneren von Getrieben anzuordnen. Dabei stehen die Steuervorrichtungen mit einem Getriebeöl in Kontakt. Die Steuervorrichtungen für Getriebesteuerungen, insbesondere in Automatikgetrieben, steuern heutzutage nicht nur Magnetventile für die hydraulische Steuerung an, sondern auch elektromotorisch angetriebene Ölpumpen, hier insbesondere, um Start-Stopp-Funktionen zu realisieren. Die erforderlichen Leistungsbauelemente in der Steuervorrichtung erzeugen hierbei eine hohe Verlustleistung, die über thermische Ableitvorrichtungen abgeführt werden.

Es ist bekannt, heutzutage Leiterplatten, Printed Circuit Boards, PCBs, im Getriebeinnenraum anstatt der früher üblichen teuren keramischen Substrate aus Al₂O₃, LTCC einzusetzen.

Um Steuervorrichtungen möglichst kompakt zu bauen, ist es bekannt, die Leiterplatten beidseitig zu bestücken.

Die DE 10 2013 215 364 beschreibt ein elektronisches Schaltungsmodul mit zu einer Leiterplatte beidseitig angeordneten Bauelementen, wobei mindestens ein Kühlkörper eine Anpresskraft in der Richtung eines zu kühlenden elektronischen Bauteils in Richtung Leiterplatte ausübt und von der Leiterplatte beabstandet ausgebildet ist.

Aus den Dokumenten DE 197 22 357 C1, US 2005/0201069 A1 und DE 10 2013 223 542 A1 des Standes der Technik sind Steuervorrichtungen mit Leiterplatten und Kühlkörpern bekannt.

### Offenbarung der Erfindung

### Vorteile der Erfindung

Ausführungsformen der vorliegenden Erfindung können in vorteilhafter Weise ermöglichen, eine kompakte Steuervorrichtung für eine Getriebesteuerung eines Kraftfahrzeugs mit einer guten Wärmeableitung bereitzustellen.

Gemäß eines ersten Aspekts der Erfindung wird eine Steuervorrichtung für eine Getriebesteuerung eines Kraftfahrzeugs geschaffen, die elektrische Bauelemente mit verschieden hohen Verlustleistungen, eine starre Leiterplatte, die auf beiden Seiten mit elektrischen Bauelementen bestückt ist, und mit mindestens einem Kühlkörper an der Leiterplatte angeordnet ist, wobei der mindestens eine Kühlkörper auf der Seite an der Leiterplatte angeordnet ist, auf der Leistungsbauelemente angeordnet sind, und die eine Vergussmasse aufweist, die zumindest teilweise die Bauelemente umschließt. Die erfindungsgemäße Steuervorrichtung zeichnet sich insbesondere dadurch aus, dass die Leiterplatte direkt auf dem Kühlkörper anliegend befestigt ist.

Aufgrund eines direkten Kontaktes zwischen Leiterplatte und Kühlkörper ergibt sich eine äußerst effektive Wärmeabfuhr von der Leiterplatte und den daran angeordneten Bauelementen. Dabei können Leistungsbauelemente, wie sie beispielsweise für die Ansteuerung einer elektrischen Pumpe notwendig sind, den kürzesten und minimalen thermischen Übergangs-Wärmepfad aufweisen.

Gemäß einer die Erfindung weiterbildenden Ausführungsform sind die Leistungsbauelemente mit einer hohen Verlustleistung auf der Seite an der Leiterplatte angeordnet, auf der der mindestens eine Kühlkörper angeordnet ist. Auf der gegenüberliegenden Seite der Leiterplatte sind Bauelemente angebaut, die eine geringere Verlustleistung erzeugen. Somit wird der Kühlkörper effizient im Betrieb der Steuervorrichtung eingesetzt.

Um die Bauelemente noch wirkungsvoller mit dem Kühlkörper zu kühlen, sind weiter bevorzugt Aussparungen zur Aufnahme von Bauelementen im Kühlkörper vorgesehen.

Um den Kühlkörper möglichst kostengünstig in hohen Volumina mit einer hohen gleichbleibenden Qualität herzustellen, ist bevorzugt der mindestens eine Kühlkörper als Blechstanzteil hergestellt, wobei insbesondere das bevorzugte Material Aluminium ist. Die Leiterplatte ist, wie eingangs beschrieben, bevorzugt derart ausgebildet, dass sie gewöhnlichen Betriebstemperaturen von beispielsweise 150°C ausreichend standhält.

Gemäß einer die Erfindung weiterbildenden Ausführungsform weisen Bauelemente mit einer elektrischen Schaltung, die auf der dem Kühlkörper gegenüberliegenden Oberseite von der Leiterplatte montiert sind, die elektrische Schaltung auf der Unterseite vom Bauelement anliegend zur Leiterplatte, d.h. slug down, auf und insbesondere Bauelemente mit einer elektrischen Schaltung, die an der unteren Seite der Leiterplatte zusammen mit dem Kühlkörper montiert sind, weisen die elektrische Schaltung auf der Oberseite von den Bauelementen aufliegend auf dem Kühlkörper, also slug up, auf. Aufgrund des spezifischen Einsetzens der besonderen Bauelemente, abhängig vom Verlustleistungstyp auf die Leiterplatte von der Steuervorrichtung, ist somit der Wärmeabführungspfad verkürzt und die Wärmeabfuhr somit effizienter.

Um die Wärmeabfuhr noch effizienter und fertigungseffizienter auszugestalten, sind bevorzugt zwei Kühlkörper gestapelt angeordnet, wobei insbesondere die beiden Kühlkörper im Fertigungsprozess stanzgenietet hergestellt sind. Die zwei gestapelten Kühlplatten bringen außerdem eine verbesserte Biegesteifigkeit mit sich. Außerdem lassen sich weitere Bauelemente durch die Verwendung von zwei Kühlplatten in Aussparungen und Vertiefungen sowie Hinterschneidungen besser und sicherer an der Leiterplatte bzw. an dem äußeren Kühlkörper befestigen und die Wärmeabführungspfade verkürzen.

Gemäß einer die Erfindung weiterbildenden Ausführungsform ist die Leiterplatte auf den Kühlkörper zur thermischen Wärmeleitung aufgeklebt und insbesondere mechanisch mit dem Kühlkörper befestigt.

Damit die Wärmeabfuhr von der Oberseite der Leiterplatte zu zumindest einem Kühlkörper an der Unterseite der Leiterplatte effektiv realisiert ist, sind Durchgänge, sogenannte Vias, durch die Leiterplatte ausgebildet. In einer die Erfindung weiterbildenden Ausführungsform weist die Leiterplatte mindestens eine dicke Kupferleiterbahn mit insbesondere 100 µm Leiterbahnstärke auf, wobei neben elektrisch leitenden Leiterbahnen thermische Leiterbahnen ausgebildet sind, zu denen Durchgänge von der Oberseite der Leiterplatte und dazu versetzte Durchgänge von der Unterseite der Leiterplatte führen und ausgebildet sind.

Um den Bauteilaufwand zu reduzieren und die Steuervorrichtung möglichst kompakt zu gestalten, ist die Steuervorrichtung als integriertes Modul mit Sensoren und Auswerte- und Steuerelektronik als aktive Bauelemente mit elektrischer Schaltung ausgebildet. Die Sensoren können beispielsweise Drucksensoren für hydraulische Vorrichtungen oder Drehzahlsensoren sein. Erfindungsgemäß ist mindestens einer der Sensoren geklemmt an der Steuervorrichtung, zwischen der Leiterplatte und einem von den mindestens zwei Kühlkörpern angeordnet und befestigt. Insbesondere kann eine weitere Sicherung am äußeren Kühlkörper zusätzlich angeordnet sein.

Um die Steuervorrichtung sicher im Getriebe zu verbauen, ist die Steuervorrichtung mittels des Kühlkörpers mechanisch am Getriebegehäuse im Getriebeinnenraum befestigbar. Hierfür weist der mindestens eine Kühlkörper, der von der Leiterplatte am weitesten beabstandet ist, Bohrungen auf, so dass die Steuervorrichtung mittels beispielsweise einer Schraubverbindung im Getriebeinnengehäuse befestigbar ist.

Gemäß einer die Erfindung weiterbildenden Ausführungsform ist eine Wärmeleitvorrichtung, insbesondere eine Wärmeleitfolie, weiter bevorzugt eine mehrlagige Wärmeleitfolie oder eine Wärmeleitfolie mit einer größeren Folienstärke zwischen Bauelement und Kühlkörper angeordnet. Somit wird ein durchgehender Wärmeleitpfad für Bauelemente, die auf der Unterseite der Leiterplatte angeordnet sind, bis zum äußeren, von der Leiterplatte beabstandeten Kühlkörper realisiert.

Es wird darauf hingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnung

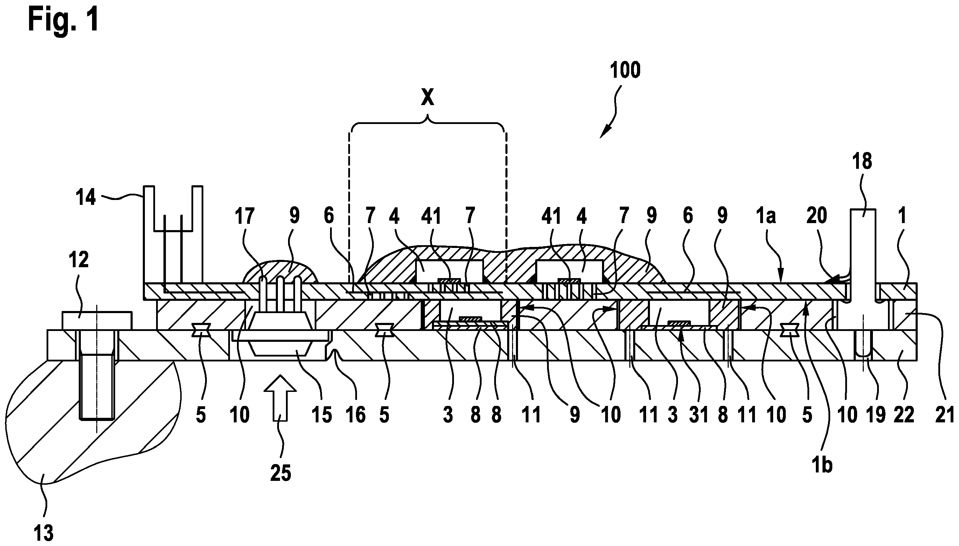

Nachfolgend werden Ausführungsformen der Erfindung unter Bezugnahme auf die beigefügte Zeichnung beschrieben, wobei weder die Zeichnung noch die Beschreibung als die Erfindung einschränkend auszulegen sind. Es zeigt
- Fig. 1: eine Querschnittansicht einer erfindungsgemäßen Steuervorrichtung.

Die Figur ist lediglich schematisch und nicht maßstabsgetreu dargestellt.

### Ausführungsformen der Erfindung

Fig. 1 zeigt im Querschnitt eine erfindungsgemäße Steuervorrichtung 100 für eine Getriebesteuerung eines Kraftfahrzeugs. Die Steuervorrichtung 100 weist eine starre Leiterplatte 1, sogenanntes Printed Circuit Board, PCB auf. Die Leiterplatte 1 ist auf beiden Seiten 1a, 1b mit elektrischen Bauelementen 3, 4, 15, 18 bestückt. Die elektrischen Bauelemente 3, 4, 15, 18 weisen verschieden hohe Verlustleistungen auf. Die Bauelemente 4, die eine geringe Verlustleistung aufweisen, sind auf der Oberseite 1a angeordnet und die Bauelemente 3, insbesondere Leistungsbauelemente mit einer hohen Verlustleistung sind auf der Unterseite 1b der Leiterplatte 1 angeordnet, auf der zwei Kühlkörper 21, 22 angeordnet sind. Die Bauelemente 4 auf der Oberseite 1a der Leiterplatte 1 sind mittels einer Vergussmasse 9 umhüllt und gegen äußere Einflüsse, beispielsweise eines Getriebeöls, abgedichtet. Ebenso sind die Leitungsenden des Bauelements 17 auf der Oberseite 1a der Leiterplatte 1 mittels Vergussmasse abgedichtet. Das Bauelement 15, das auf der Unterseite 1b der Leiterplatte 1 montiert ist, dessen Anschlussspitzen auf der Oberseite 1a der Leiterplatte 1 herausschauen, sind ebenfalls mit der Vergussmasse 9 abgedichtet. Die Leiterplatte 1 liegt erfindungsgemäß direkt auf dem Kühlkörper 21 auf. Der Kühlkörper 21 weist Aussparungen 10 auf, in denen Bauelemente 3 und Leistungsbauelemente sowie elektronische Sensoren 15, 18 angeordnet sind. Somit sind Wärmeleitpfade und thermische Übergänge verkürzt und minimiert. Längere Wärmepfade und längere thermische Übergänge gibt es zu Bauelementen 4, die eine geringere Verlustleistung aufweisen. Leistungsbauelemente 3, zum Beispiel für die Ansteuerung einer elektrischen Pumpe, sind auf der Unterseite 1b der Leiterplatte 1 angeordnet.

Der Kühlkörper 21 sowie der zweite Kühlkörper 22 sind beide bevorzugt ein Blechstanzteil aus Aluminium und sind mittels Nieten 5 vernietet oder geclincht. Die Leiterplatte 1 ist eine herkömmliche Leiterplatte, die einer Betriebstemperatur von 150°C ausreichend standhält und deshalb nicht aus einer Keramik hergestellt sein muss.

Die Bauelemente 3 mit einer hohen Verlustleistung, die auf der Unterseite 1b der Leiterplatte 1 angeordnet sind, sind in einer sogenannten slug up-Ausführung eingesetzt. Bei dieser Ausführung sind die elektrische Schaltung 31 beabstandet zur Leiterplatte 1 in der Nähe aufliegend auf dem zweiten Kühlkörper 22 an der Oberfläche des Bauelements 3 angeordnet. Bei der in Fig. 1 gezeigten besonderen Ausführungsform ist entweder eine Wärmeleitfolie 8 zwischen dem Bauelement 3 mit der elektrischen Schaltung 31 jeweils mittels einer Lage oder zweilagig auf dem Kühlkörper 22 aufliegend dargestellt. Die Aussparung 10 des Kühlkörpers 21, in dem jeweils das Bauelement 3 mit einer Wärmeleitfolie 8 angeordnet ist, ist mittels der Vergussmasse 9 aufgefüllt. Die Vergussmasse 9 ist ebenfalls wärmeleitend und wärmeabführend ausgebildet.

Auf der Oberseite 1a der Leiterplatte 1 sind Bauelemente 4 mit einer elektrischen Schaltung 41 in einer slug down-Ausführung angeordnet. Bei diesen Bauelementen 4 sind die elektrischen Schaltungen 41 auf der Bauteilunterseite angeordnet, so dass sie direkt auf der Leiterplatte 1 anliegen. Um hier die Wärme von der elektrischen Schaltung 41 abzuführen, sind Durchgänge 7, sogenannte Vias, durch die Leiterplatte 1 ausgebildet, die die Wärme von Bauelement 4 zum Kühlkörper 21 und 22 abführen.

Im Abschnitt X, bei dem in der Fig. 1 gezeigten linken Bauelement 4, ist eine besondere Wärmeleitkonstruktion realisiert. Hier sind einer dicken Kupferschicht in der Leiterplatte 1, z.B. mit einer Stärke von 100 µm nicht nur elektrische Leiterbahnen zugeordnet, sondern mindestens eine in sich abgeschlossene thermische Leiterbahn 6 ist dadurch geschaffen, dass Durchgänge 7 von der Oberseite 1a der Leiterplatte 1 unter dem Bauelement 4 und der elektrischen Schaltung 41 zur in der Leiterplatte 1 angeordneten Kupferleiterbahn 6 führen und versetzt dazu Durchgänge 7 von der Kupferleiterbahn 6 zur Unterseite 1b der Leiterplatte 1 ausgebildet sind. An der Unterseite 1b liegt hier direkt der Kühlkörper 21 auf, so dass die Wärme hier über den Kühlkörper 21 und den daran befestigten Kühlkörper 22 abgezogen wird. Somit wird über die Kupferleiterbahn 6 Wärme auf dem Bauelement 4 an die Kühlkörper 21, 22 direkter herausgeführt. Damit die Wärme von der Leiterplatte 1 auf den Kühlkörper 21, 22 effizient übergeht, ist die Leiterplatte 1 auf den Kühlkörper 21 für einen kurzen thermischen Wärmepfad aufgeklebt und zusätzlich mechanisch befestigt.

Die Steuervorrichtung 100 ist ein integriertes Modul mit Sensoren und aktiven Bauelementen mit elektrischer Schaltung, die eine Auswerte- und/oder Steuerelektronik umfassen. Die Bauelemente 3 können unterschiedliche Bauhöhen aufweisen. Dieser Höhenunterschied wird durch eine oder mehrere Lagen der Wärmeleitfolie 8 oder durch eine stärkere Foliendicke ausgeglichen. Die Bauelemente 3 liegen direkt auf dem Kühlkörper 22 oder mittelbar über einer Wärmeleitfolie 8. Die Bauelemente 3 haben daher einen kurzen thermischen Übergang und einen sehr kurzen Wärmepfad.

Die Vergussmasse 9, die eine Kunststoffmasse ist, wird auf der Leiterplattenunterseite 1b über Bohrungen 11 im Kühlkörper 22 zu den Hohlräumen und Aussparungen 10 vergossen, in denen die Bauelemente 3 angeordnet sind. Die Steuervorrichtung 100 wird im Innenraum beispielsweise mittels Verschraubungen 12 im Innenraum eines Getriebes befestigt. Bevorzugt ist das Steuergerät auf hydraulischen Schaltplatten 13 befestigt, wobei hierdurch die in den Kühlkörpern 21, 22 eingebrachte Verlustleistung an die große thermische Masse der Schaltplatten weitergeleitet werden kann. Die Leiterplatte 1 weist mindestens einen Steckverbinder 14 als Buchse oder Stecker auf, der mit einem Fahrzeugkabelbaum kontaktiert ist und mit dem auch weitere Sensoren elektrisch kontaktierbar sind. Die weiteren Sensoren sind Drehzahl-, Positions- und/oder Drucksensoren.

Wie in der Fig. 1 gezeigt, können auch Drucksensoren 15 direkt in die Kühlkörperplatte 21, 22 eingesetzt sein. Es können Druckkräfte 25, die mit dem Pfeil 25 dargestellt sind, über die Kühlkörperplatte 21 abgestützt werden. Mittels einer Verstemmung 16 wird der Drucksensor 15 zusätzlich and dem Kühlkörper 21 aufliegend und mittels des Kühlkörpers 22 klemmend und formschlüssig mechanisch fixiert. Der Drucksensor ist an den Anschlussstiften, sog. Kontaktpins, mit der Leiterplatte 1 auf der Oberseite 1a verlötet.

Beispielsweise können Drehzahlsensoren 18 zwischen der Leiterplatte 1 und der Kühlkörperplatte 22 geklemmt werden und durch Bohrungen 19 in der Platte 22 genau positioniert werden. Die Drehzahlsensoren 18 sind mit der Leiterplatte 1 ebenfalls über Lötstellen 20, an der Oberseite 1a elektrisch leitend verlötet. Obwohl nur teilweise explizit in Fig. 1 dargestellt, sind alle Kontaktstellen der Sensoren 15 und 18 sowie die Bauelemente 4 durch die Vergussmasse 9 aus Kunststoff hinsichtlich Umgebungseinflüssen, wie Kurzschlüsse durch Metallpartikel oder Bildung von leitenden Ablagerungen geschützt.. Das Getriebeöl kann elektrisch leitende Metalle in Folge von Verschleiß und Abrieb umfassen, die einen Kurzschluss herbeiführen könnten. Ebenso ist bekannt dass Getriebeöl in Verbindung mit anderen Materialien und hohen Temperaturen leitenden Ablagerungen bilden welche auch zu elektrischen Kurzschlüssen führen. Durch die Abdeckung alle elektrischen Kontaktstellen mit der Vergussmasse werden diese negativen Effekte vermieden. Somit ist ein Gehäuse, das mechanisch abgedichtet und verschließbar ist, aufgrund des Einsetzens eines Kunststoffgusses als Vergussmasse 9 nicht mehr notwendig und kann eingespart werden. Somit ist dargestellt, wie eine effiziente Wärmeableitung in einer Steuervorrichtung 100 realisiert ist.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Steuervorrichtung (100) für eine Getriebesteuerung eines Kraftfahrzeugs aufweisend:
elektrische Bauelemente (3, 4) mit verschieden hohen Verlustleistungen, eine starre Leiterplatte (1), die auf beiden Seiten (1a, 1b) mit elektrischen Bauelementen (3, 4) bestückt ist,
mindestens einen Kühlkörper (21, 22) an der Leiterplatte (1) angeordnet, wobei der mindestens eine Kühlkörper (21, 22) auf der Seite (1b) an der Leiterplatte (1) angeordnet ist, auf der Leistungsbauelemente (3) angeordnet sind,
eine Vergussmasse (9), die zumindest teilweise die Bauelemente (3, 4) umschließt,
wobei die Leiterplatte (1) direkt auf dem Kühlkörper (21) anliegend befestigt ist, **dadurch gekennzeichnet, dass** die Steuervorrichtung (100) als integriertes Modul mit Sensoren (15, 18) und Auswerte- und Steuerelektronik ausgebildet ist und mindestens ein Sensor zwischen Leiterplatte (1) und Kühlkörper (21, 22) geklemmt und daran befestigt ausgeführt ist.

2. Steuervorrichtung (100) nach Anspruch 1, **dadurch gekennzeichnet, dass** der mindestens eine Kühlkörper (21, 22) Aussparungen (10) zur Aufnahme von Bauelementen (3) aufweist.

3. Steuervorrichtung (100) nach Anspruch 1 oder 2, **dadurch gekennzeichnet, dass** der mindestens eine Kühlkörper (21, 22) als Blechstanzteil, insbesondere aus Aluminium, hergestellt ist.

4. Steuervorrichtung (100) nach Anspruch 1, 2 oder 3, **dadurch gekennzeichnet, dass** die Bauelemente (4) mit einer elektrischen Schaltung (41), die auf der dem Kühlkörper (21) gegenüberliegenden Oberseite (1a) von der Leiterplatte (1) montiert sind, die elektrische Schaltung (41) auf der Unterseite anliegend zur Leiterplatte (1) aufweisen und die Bauelemente (3) mit einer elektrischen Schaltung (31), die an der unteren Seite (1b) von der Leiterplatte (1) zusammen mit dem Kühlkörper (21) montiert sind, die elektrische Schaltung (31) auf der Oberseite vom Bauelement (3) aufliegend auf dem Kühlkörper (22) aufweisen.

5. Steuervorrichtung (100) nach einem der Ansprüche 1 bis 4, **dadurch gekennzeichnet, dass** zwei Kühlkörper (21, 22) gestapelt angeordnet sind, insbesondere die beiden Kühlkörper (21, 22) im Fertigungsprozess stanzgenietet hergestellt sind.

6. Steuervorrichtung (100) nach einem der Ansprüche 1 bis 5, **dadurch gekennzeichnet, dass** die Leiterplatte (1) auf den Kühlkörper (21) zur thermischen Wärmeleitung aufgeklebt ist, und insbesondere mechanisch mit dem Kühlkörper (21) befestigt ist.

7. Steuervorrichtung (100) nach einem der Ansprüche 1 bis 6, **dadurch gekennzeichnet, dass** Durchgänge (7) durch die Leiterplatte (1) ausgebildet sind, die Leiterplatte (1) mindestens eine dicke Kupferleiterbahn (6), insbesondere mit 100µm Leiterbahnstärke, aufweist, wobei thermische Leiterbahnen (6) neben stromführenden Leiterbahnen auf der Leiterplatte (1) ausgebildet sind, die mit Durchgängen (7) zur Oberseite (1a) der Leiterplatte (1) und dazu versetzte Durchgänge (7) zur Unterseite (1b) der Leiterplatte (1) ausgebildet sind.

8. Steuervorrichtung (100) nach einem der Ansprüche 1 bis 7, **dadurch gekennzeichnet, dass** die Steuervorrichtung (100) mittels des Kühlkörpers (21) mechanisch am Getriebegehäuse oder Schaltplatten (13) im Getriebeinnenraum befestigbar ist, wobei der Kühlkörper Bohrungen aufweist, so dass die Steuervorrichtung mittels Schraubverbindungen in einem Getriebeinnengehäuse befestigbar ist.

9. Steuervorrichtung (100) nach einem der Ansprüche 1 bis 8, **dadurch gekennzeichnet, dass** eine Wärmeleitvorrichtung, insbesondere einer Wärmeleitfolie (8), weiter bevorzugt eine mehrlagigen Wärmeleitfolie (8) oder einer Wärmeleitfolie (8) mit einer stärkeren Lage, zwischen Bauelement (3, 4) und Kühlkörper (21, 22) angeordnet ist.

## Claims

1. Control device (100) for a gearbox control system of a motor vehicle comprising:
electrical components (3, 4) with different levels of power loss,
a rigid circuit board (1) populated on both sides (1a, 1b) with electrical components (3, 4),
at least one cooling body (21, 22) disposed on the circuit board (1),
wherein the at least one cooling body (21, 22) is disposed on the side (1b) on the circuit board (1) on which power components (3) are disposed,
a potting material (9) at least partly enveloping the components (3, 4),
wherein the circuit board (1) is attached to the cooling body (21) in direct contact, **characterized in that** the control device is embodied as an integrated module with sensors (15, 18) and analysis and control electronics and at least one sensor is clamped between the circuit board (1) and the cooling body (21, 22) and attached thereto.

2. Control device (100) according to Claim 1, **characterized in that** the at least one cooling body (21, 22) comprises apertures (10) for accommodating components (3) .

3. Control device (100) according to Claim 1 or 2, **characterized in that** the at least one cooling body (21, 22) is manufactured as a sheet metal stamping, in particular of aluminium.

4. Control device (100) according to Claim 1, 2 or 3, **characterized in that** the components (4) with an electrical circuit (41) that are mounted on the upper side (1a) of the circuit board (1) opposite the cooling body (21) comprise the electrical circuit (41) on the underside in contact with the circuit board (1), and the components (3) with an electrical circuit (31) that are mounted on the underside (1b) of the circuit board (1) together with the cooling body (21) comprise the electrical circuit (31) on the upper side of the component (3) in contact with the cooling body (22).

5. Control device (100) according to one of Claims 1 to 4, **characterized in that** two cooling bodies (21, 22) are disposed in a stack, in particular the two cooling bodies (21, 22) are manufactured by punch riveting during the manufacturing process.

6. Control device (100) according to one of Claims 1 to 5, **characterized in that** the circuit board (1) is glued onto the cooling body (21) for thermal heat conduction, and in particular is mechanically attached to the cooling body (21).

7. Control device (100) according to one of Claims 1 to 6, **characterized in that** leadthroughs (7) are formed through the circuit board (1), the circuit board (1) comprises at least one thick copper conductive track (6), in particular with a 100 µm conductive track thickness, wherein thermally conductive tracks (6) in addition to current-conducting conductive tracks are formed on the circuit board (1) and are embodied with leadthroughs (7) to the upper side (1a) of the circuit board (1) and leadthroughs (7) that are offset thereto to the underside (1b) of the circuit board (1).

8. Control device (100) according to one of Claims 1 to 7, **characterized in that** the control device (100) can be mechanically attached to the gearbox housing or circuit boards (13) in the interior of the gearbox by means of the cooling body (21), wherein the cooling body comprises bores, so that the control device can be fastened in an inner gearbox housing by means of a threaded connection.

9. Control device (100) according to one of Claims 1 to 8, **characterized in that** a heat-conducting arrangement, in particular a heat-conducting film (8), more preferably a multilayer heat-conducting film (8) or a heat-conducting film (8) with a thicker layer, is disposed between the component (3, 4) and the cooling body (21, 22).

## Revendications

1. Dispositif de commande (100) pour une commande de boîte de vitesses d'un véhicule automobile, présentant :
des composants électriques (3, 4) ayant des puissances dissipées de différents niveaux,
une carte de circuits imprimés rigide (1) qui est équipée de composants électriques (3, 4) sur les deux faces (1a, 1b),
au moins un dissipateur de chaleur (21, 22) disposé sur la carte de circuits imprimés (1),
ledit au moins un dissipateur de chaleur (21, 22) étant disposé sur la face (1b) de la carte de circuits imprimés (1) sur laquelle sont disposés les composants de puissance (3),
une masse de scellement (9) qui entoure les composants (3, 4) au moins en partie,
la carte de circuits imprimés (1) étant fixée de manière directement adjacente au dissipateur de chaleur (21),
**caractérisé en ce que** le dispositif de commande (100) est réalisé sous la forme d'un module intégré muni de capteurs (15, 18) et d'une électronique d'évaluation et de commande, et au moins un capteur est réalisé en étant inséré entre la carte de circuits imprimés (1) et le corps de réfrigérant (21, 22) et en y étant fixé.

2. Dispositif de commande (100) selon la revendication 1, **caractérisé en ce que** ledit au moins un dissipateur de chaleur (21, 22) présente des évidements (10) pour recevoir des composants (3).

3. Dispositif de commande (100) selon la revendication 1 ou 2, **caractérisé en ce que** ledit au moins un dissipateur de chaleur (21, 22) est fabriqué sous la forme d'une pièce en tôle découpée, en particulier en aluminium.

4. Dispositif de commande (100) selon la revendication 1, 2 ou 3, **caractérisé en ce que** les composants (4) munis d'un circuit électrique (41) qui sont montés sur la face supérieure (la), opposée au dissipateur de chaleur (21), de la carte de circuits imprimés (1) présentent le circuit électrique (41) sur la face inférieure de manière adjacente à la carte de circuits imprimés (1), et les composants (3) munis d'un circuit électrique (31) qui sont montés sur la face inférieure (1b) de la carte de circuits imprimés (1) conjointement avec le dissipateur de chaleur (21) présentent le circuit électrique (31) sur la face supérieure du composant (3) de manière posée sur le dissipateur de chaleur (22).

5. Dispositif de commande (100) selon l'une quelconque des revendications 1 à 4, **caractérisé en ce que** deux dissipateurs de chaleur (21, 22) sont disposés en étant empilés, en particulier **en ce que** les deux dissipateurs de chaleur (21, 22) sont fabriqués selon un processus de production par auto-rivetage.

6. Dispositif de commande (100) selon l'une quelconque des revendications 1 à 5, **caractérisé en ce que** la carte de circuits imprimés (1) est collée sur le dissipateur de chaleur (21) pour la conduction thermique, et est en particulier fixée mécaniquement au dissipateur de chaleur (21).

7. Dispositif de commande (100) selon l'une quelconque des revendications 1 à 6, **caractérisé en ce que** des passages (7) sont réalisés à travers la carte de circuits imprimés (1), la carte de circuits imprimés (1) présente au moins une piste conductive en cuivre épaisse (6), en particulier d'une épaisseur de piste conductive de 100 pm, des pistes conductives thermiques (6) étant réalisées à côté de pistes conductives électroconductrices sur la carte de circuits imprimés (1) qui sont réalisées avec des passages (7) vers la face supérieure (la) de la carte de circuits imprimée (1) et des passages (7) décalés par rapport à ceux-ci vers la face inférieure (1b) de la carte de circuits imprimés (1).

8. Dispositif de commande (100) selon l'une quelconque des revendications 1 à 7, **caractérisé en ce que** le dispositif de commande (100) peut être fixé mécaniquement au carter de boîte de vitesses au moyen du dissipateur de chaleur (21) ou des plaquettes de circuits imprimés (13) peuvent être fixées dans l'espace intérieur de la boîte de vitesses, le dissipateur de chaleur présentant des perçages de sorte que le dispositif de commande peut être fixé au moyen de vissages dans le carter intérieur de boîte de vitesses.

9. Dispositif de commande (100) selon l'une quelconque des revendications 1 à 8, **caractérisé en ce qu'**un dispositif thermoconducteur, en particulier un film thermoconducteur (8), de plus grande préférence un film thermoconducteur multicouche (8) ou un film thermoconducteur (8) ayant une couche plus épaisse, est disposé entre le composant (3, 4) et le dissipateur de chaleur (21, 22).
